(19) Europäisches Patentamt / European Patent Office / Office européen des brevets

(11) **EP 2 447 989 B1**

(12) **EUROPEAN PATENT SPECIFICATION**

(45) Date of publication and mention
of the grant of the patent:
**04.05.2016 Bulletin 2016/18**

(21) Application number: **09846434.0**

(22) Date of filing: **22.06.2009**

(51) Int Cl.:
*H01L 23/00* (2006.01)    *H01L 23/055* (2006.01)
*H01L 23/13* (2006.01)    *H01L 23/14* (2006.01)
*H01L 23/24* (2006.01)    *H01L 23/498* (2006.01)
*H05K 3/34* (2006.01)

(86) International application number:
**PCT/JP2009/002813**

(87) International publication number:
**WO 2010/150297 (29.12.2010 Gazette 2010/52)**

(54) **SEMICONDUCTOR PACKAGE AND SEMICONDUCTOR PACKAGE MOUNTING STRUCTURE**

HALBLEITERGEHÄUSE UND MONTAGESTRUKTUR FÜR EIN HALBLEITERGEHÄUSE

BOÎTIER DE SEMI-CONDUCTEUR ET STRUCTURE DE MONTAGE DE BOÎTIER DE SEMI-CONDUCTEUR

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**02.05.2012 Bulletin 2012/18**

(73) Proprietor: **Mitsubishi Electric Corporation Tokyo 100-8310 (JP)**

(72) Inventors:
• **HAMAGUCHI, Tsuneo**
  **Tokyo 100-8310 (JP)**
• **SUGIURA, Ikio**
  **Tokyo 100-8310 (JP)**
• **SAKAMOTO, Hiroo**
  **Tokyo 100-8310 (JP)**
• **IWATA, Masaki**
  **Tokyo 100-8310 (JP)**
• **SHIRASE, Takashi**
  **Tokyo 100-8310 (JP)**
• **OKAMURO, Takashi**
  **Tokyo 100-8310 (JP)**

(74) Representative: **Hoffmann Eitle
Patent- und Rechtsanwälte PartmbB
Arabellastraße 30
81925 München (DE)**

(56) References cited:
EP-A1- 1 050 906          EP-A1- 1 876 642
EP-A2- 1 534 054          WO-A1-01/19145
WO-A1-2008/059741    JP-A- S5 954 247
JP-A- 11 150 211          JP-A- 11 150 211
JP-A- 2004 140 385        JP-A- 2007 200 997
US-A- 4 872 825          US-A- 5 677 045
US-A1- 2002 024 130    US-A1- 2007 057 364
US-A1- 2007 057 364

**Description**

Field

The present invention relates to a semiconductor package including a recessed portion for housing a semiconductor element and side electrodes for soldering, and the implementation structure thereof.

Background

As a conventional semiconductor package, for example, there is a package implemented on a motherboard by arranging external connection leads on the outer side surfaces of the package wiring board and soldering these wires to the electrode mounted on the motherboard, such as a small outline package (SOP) and a quad flat package (QFP), (Patent Literature 1 and Non Patent Literature 1, for example). Such semiconductor packages, however, are easy to observe the soldered portion but require a large area to implement on the motherboard.

For this reason, there is a conventional semiconductor package that is easy to observe the soldered portion and requires a small area to implement on the motherboard by integrally forming an electrode (hereinafter, "side electrode") on the outer side surface and the bottom surface (surfaces for implementing on the motherboard) of the package wiring board (Patent Literature 2, for example). Such a semiconductor package is implemented on the motherboard, with solder being spread and solderable between the side electrode arranged on the package wiring board and the electrode arranged on the motherboard.

The conventional package wiring board including the side electrodes has a ceramic multilayered structure with a recessed portion therein for housing a semiconductor element. Then, the recessed portion of this package wiring board is prepared by forming an opening in at least one of multiple ceramic green sheets, and then laminating the ceramic green sheets and burning them at a high temperature. At this point, the thermal expansion coefficient of the package wiring board in the planar direction is approximately $7 \times 10^{-6}$ 1/K. Here, the "planar direction" represents the direction parallel to the implementation surface of the package wiring board. On the other hand, if the motherboard is a generally used glass epoxy print wiring board, its thermal expansion coefficient in the planar direction is approximately $16 \times 10^{-6}$ 1/K. Thus, because there is a large difference between the thermal expansion coefficients of the two in the planar direction, large distortion occurs in the soldered portion between the package wiring board and the motherboard in an environment in which rise and fall of temperature are repeated, which tends to produce cracks.

Patent Literature 2 discloses a soldering technology in which solder paste that contains spacers is employed for soldering to improve the soldering strength between the package wiring board and the motherboard and enhance the soldering reliability.

Patent Literature 3 describes a hybrid IC module in which a dielectric constant of fibers in a woven and nonwoven cloth forming a part of a substrate can be made low and the thermal expansion coefficient of the fibers can be set at a value equal to or higher than that of a metallic material of a coating having a good conductivity. The module consists of a woven or nonwoven cloth made of polytetrafluoroethylene fibers impregnated with synthetic resin which can be subjected to press molding or die molding to form a substrate having a recess. Further, an electric circuit is formed on a front surface of the substrate and various types of electronic components are mounted in the recess and further the recess is sealed hermetically with a sealing means.

Further related devices and materials are described in Patent Literature 4 to 8.

Citation List

Patent Literature

Patent Literature 1: Japanese Patent Application Laid-open No. H9-326545 (Paragraphs 0003 and 0004, FIG. 6)
Patent Literature 2: Japanese Patent Application Laid-open No. 2007-200997 (Paragraphs 0019 and 0020, FIG. 1)
Patent Literature 3: Japanese Patent Application Laid-open No. 11150211 A
Patent Literature 4: US 5 677 045 A
Patent Literature 5: WO 2008/059741 A1
Patent Literature 6: US 4 872 825 A
Patent Literature 7: EP 1 534 054 A2
Patent Literature 8: JP 2004 140385 A
Patent Literature 9: US 2007/0057364 A1

Non Patent Literature

Non Patent Literature 1: "Erekutoronikusu Jisso Gijutsu Kiso Koza" (Electronics implementation technique basic course), vol.4, p.158, 1997, Kogyo Chosakai Publishing, Co., Ltd.

Summary

Technical Problem

With the soldering method according to Patent Literature 2, however, the solder paste that contains spacers is adopted, and therefore a sufficient adhesion strength cannot be attained because of the soldering area that is reduced in accordance with the downsizing of the semiconductor package, as a result of which cracks are still produced in the soldered portion.
The present invention has been made to solve the above problems, and an object is to improve the soldering reliability of a semiconductor package that includes a recessed portion for housing a semiconductor element and side electrodes for soldering.

Solution to Problem

A semiconductor package according to the present invention includes: a package wiring board which has an element housing recessed portion on a top surface thereof for housing a semiconductor element; a plurality of side electrodes which are arranged on outer side surfaces of the package wiring board and soldered to a plurality of motherboard electrodes arranged on a motherboard; a semiconductor element which is fixed onto a bottom surface of the element housing recessed portion; and an element electrode arranged on the bottom surface of the element housing recessed portion and electrically connected to the semiconductor element and the side electrodes, wherein the package wiring board has a multilayered structure in which woven fabric and a resin adhesive layer are alternately laminated, a top surface of the multilayered structure being cut off to form the element housing recessed portion (2a; 42a), and the package wiring board (2; 42) is internally wired by a conductive material to electrically connect the side electrode and the element electrode; and the resin adhesive layer is formed of a resin adhesive that contains inorganic filler particles, wherein on the outer side surfaces of the package wiring board electrode recessed portions are formed into semicircular columns, designed to cut through a bottom surface of the wiring board, but not the top surface thereof and side portions of the side electrodes are arranged on each recessed portion.
Furthermore, a semiconductor package implementation structure according to the present invention includes: the semiconductor package according to any one of claims 1 to 6; a motherboard on which the semiconductor package is mounted; a plurality of motherboard electrodes which are arranged on a surface of the motherboard and attached to the side electrodes by use of solder, wherein the side electrodes and the motherboard electrodes are arranged such that a surface extending from the side electrodes crosses the motherboard electrodes; and the solder is spread and becomes solderable between top surfaces of the motherboard electrodes and the side electrodes.

Advantageous Effects of Invention

According to the present invention, a package wiring board has a multilayered structure in which woven fabric and resin adhesive layers are alternately laminated, and the resin adhesive layers contain inorganic filler particles. Hence, crack occurrence is suppressed in the soldered portion in an environment where rise and fall of temperature are repeated, and thereby the soldering reliability can be improved.

Brief Description of Drawings

FIG. 1 is a perspective view of the implementation structure of a semiconductor package 1 according to the first embodiment of the present invention.
FIG. 2 is a perspective view of the semiconductor package 1 illustrated in FIG. 1.
FIG. 3 is a section A-A of FIG. 1.
FIG. 4 is an enlarged section view of a portion of a wiring board 2 that is circled by a dot-dash line in FIG. 3.
FIG. 5 is a graph that represents the relationship between the thermal expansion coefficient of the wiring board 2 in the direction of lamination and an equivalent plastic strain of a solder 9 according to the first embodiment of the present invention.

FIG. 6 is a graph that represents the relationship between the silica particle content in a resin adhesive layer 22 of the wiring board 2 and the thermal expansion coefficient of the wiring board 2 in the direction of lamination according to the first embodiment of the present invention.

FIG. 7 is a sectional view of another implementation structure of the semiconductor package 1 according to the first embodiment of the present invention.

FIG. 8 is a sectional view of another example of the semiconductor package 1 according to the first embodiment of the present invention.

FIG. 9 is a sectional view of an implementation structure of a semiconductor package according to the second embodiment of the present invention.

FIG. 10 is a sectional view of an implementation structure of a semiconductor package according to the third embodiment of the present invention.

FIG. 11 is a sectional view of an implementation structure of a semiconductor package according to the fourth embodiment of the present invention.

FIG. 12 is a sectional view of an implementation structure of a semiconductor package according to the fifth embodiment of the present invention.

FIG. 13 is a perspective view of an optical semiconductor module according to the sixth embodiment of the present invention.

FIG. 14 is a section B-B of FIG. 13.

Description of Embodiments

First Embodiment

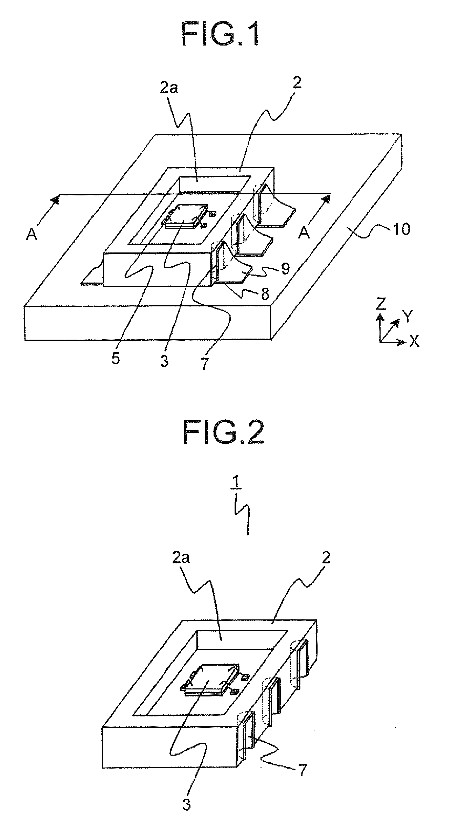

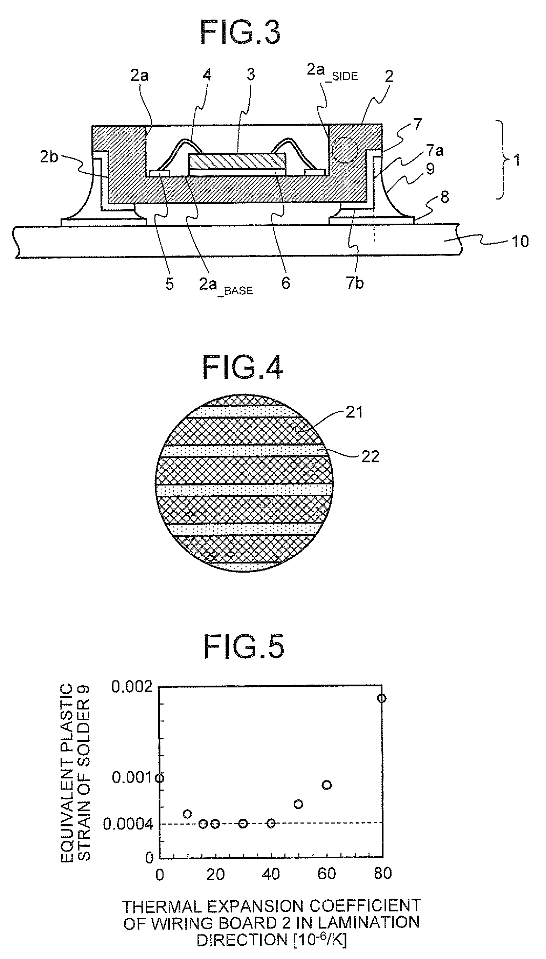

The first embodiment of the present invention is explained with reference to FIGS. 1 to 8. FIG. 1 is a perspective view of the implementation structure of a semiconductor package according to the first embodiment of the present invention, FIG. 2 is a perspective view of the semiconductor package 1 illustrated in FIG. 1, and FIG. 3 is a section A-A of the implementation structure of the semiconductor package illustrated in FIG. 1.

As shown in FIGS. 1 to 3, the semiconductor package 1 includes a wiring board 2, a semiconductor element 3, element electrodes 5, and side electrodes 7. The wiring board 2 having an outside shape of roughly a rectangular solid is internally wired by a not-shown conductive material, and is formed into a multi-layered structure. In addition, the wiring board 2 is mounted onto a motherboard 10 by soldering, and an element housing recessed portion 2a is formed in the surface (top surface) opposite of the mounting surface (bottom surface) to house the semiconductor element 3. The element housing recessed portion 2a is rectangle in shape extending in a planar direction. The "planar direction" is a direction parallel to the mounting surface of the package wiring board, as indicated in the direction of the XY plane in FIG. 1. The semiconductor element 3 is adhered to a bottom surface $2a\_{BASE}$ of the element housing recessed portion 2a with an adhesive 6, and is electrically connected to the element electrodes 5 that are arranged on the bottom surface $2a\_{BASE}$ of the element housing recessed portion 2a by wires 4. The conductive material used in the internal wiring of the wiring board 2 and also the material of the element electrodes 5 are copper. The shapes of the wiring board 2 and the element housing recessed portion 2a are not limited to the ones described in the present embodiment.

On a pair of opposing outer side surfaces of the wiring board 2, electrode recessed portions 2b are formed into semicircular columns extending from the bottom surface to the vicinity of the top surface. The electrode recessed portions 2b are designed to cut through the bottom surface of the wiring board 2 but not the top surface thereof. The electrode recessed portions 2b, however, may be designed to cut through the bottom and top surfaces of the wiring board 2. Furthermore, as for the arrangement of the side electrodes 7 onto the wiring board 2, as shown in FIG. 1, side portions 7a of the side electrodes 7 do not always have to be arranged only on a pair of opposing outer side surfaces of the wiring board 2, but may be provided on all the outer side surfaces.

The side electrode 7 includes a side portion 7a arranged on the each electrode recessed portion 2b of the wiring board 2 and a bottom portion 7b arranged on the bottom surface of the portion wiring board 2. Then, the side electrode 7 is combined with the wiring board 2 by coating the outer circumferential surface of the wiring board 2 with copper-nickel-gold plating. In this manner, because the side electrode 7 includes the bottom portion 7b, the side electrode 7 is prevented from coming off of the wiring board 2. In addition, the side electrode 7 is electrically connected to the element electrode 5 by way of the internal wiring of the wiring board 2.

The motherboard 10 on which the semiconductor package 1 is mounted is a glass epoxy print wiring board. On the surface of the motherboard 10, a plurality of motherboard electrodes 8 that are corresponding to the multiple side electrodes 7 are arranged. The semiconductor package 1 is electrically and mechanically connected to the motherboard 10 by soldering between these side electrodes 7 and the motherboard electrodes 8. Lead-free soldering is a preferable material of the solder 9, such as Sn-3Ag-0.5Cu and SnAg.

The side electrode 7 and the motherboard electrode 8 are arranged such that the surface extending from the side portion 7a of the side electrode 7 (dotted line in FIG. 3) crosses the motherboard electrode 8. In other words, the two are positioned in such a manner that the two ends of the motherboard electrode 8 are laid across the surface extending from the side portion 7a of the side electrode 7, when viewed from the planar direction in FIG. 3. By arranging the both in this manner, the solder 9 is spread out and becomes solderable between the top surface of the motherboard electrode 8 and the bottom portion 7b and the side portion 7a of the side electrode 7 in soldering of the surface installation and in soldering with the laser, lamp, or hot-air heating method. In this implementation structure, the soldering state becomes easier to observe than in the arrangement of leads on the outer side surface of the package wiring board as in Patent Literature 1, while the mounting area of the semiconductor package 1 onto the motherboard 10 can be reduced.

The structure of the wiring board 2 is explained in detail with reference to FIG. 4. FIG. 4 is an enlarged sectional view of the wiring board 2 encircled by the dot-dash line in FIG. 3. The wiring board 2 has a multilayered structure in which woven fabric 21 and a resin adhesive layer 22 are alternately laminated. Preferably, the material of the woven fabric 21 should have a thermal expansion coefficient of approximately $1 \times 10^{-6}$ to $10 \times 10^{-6}$ l/K in the thickness direction (Z axis direction in FIG. 1), examples of which include resin woven fabric such as glass woven fabric and aramid woven fabric. On the other hand, as the material of the resin adhesive of the resin adhesive layers 22, an epoxy resin, a phenol resin, a polyimide resin may be adopted. Especially by adopting glass fabric for the material of the woven fabric 21 and an epoxy resin for the material of the resin adhesive of the resin adhesive layers 22, the thermal expansion coefficient in the planar direction can be matched to that of the motherboard that is a glass epoxy print wiring board.

Unlike a recessed portion in the conventional wiring board having a ceramic multilayered structure, the element housing recessed portion 2a of the wiring board 2 is formed by preparing a wiring board in advance to have a multilayered structure in which the woven fabric 21 and the resin adhesive layer 22 are alternately laminated, and then cutting off the surface (top surface) opposite of the mounting surface (bottom surface). In this manner, the resin adhesive of the resin adhesive layers 22 is prevented from flowing into the inside of the element housing recessed portion 2a, which tends to occur when forming a recessed portion during the deposition of layers.

The resin adhesive layer 22 include inorganic filler particles. As the material of the inorganic filler particles, any inorganic substance with a low thermal expansion coefficient can be adopted, examples of which include silica ($SiO_2$) particles and ceramic particles. Especially because of their low cost and ease of processing into a desired size, silica particles serve as the most suitable material.

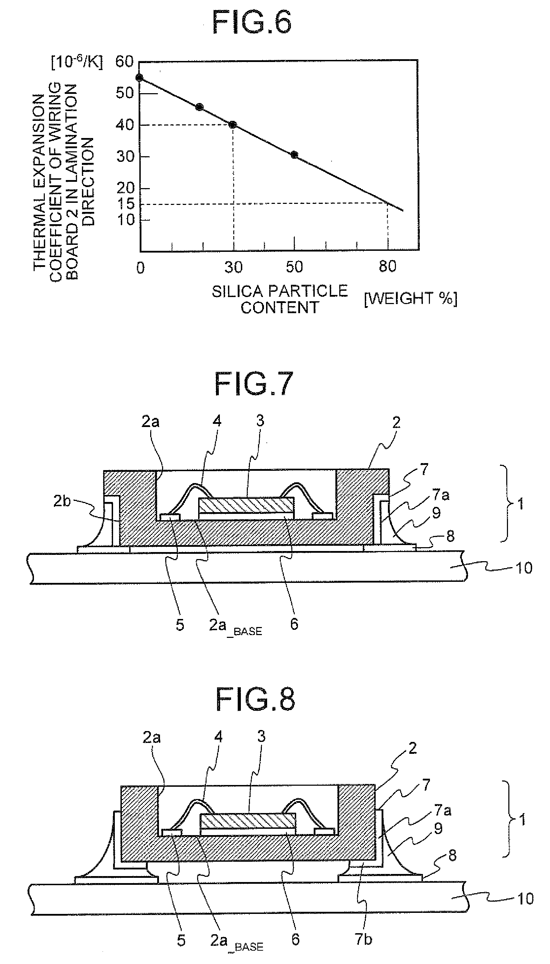

The inventors of the present invention have determined the suitable range of the inorganic filler particle content in the following manner. Hereinafter, this is explained with reference to FIGS. 5 and 6. FIG. 5 is a graph representing the relationship between the thermal expansion coefficient of the wiring board 2 in the direction of lamination and the equivalent plastic strain of the solder 9, and FIG. 6 is a graph representing the experimentally obtained relationship between the silica particle content in the resin adhesive layer 22 and the thermal expansion coefficient of the wiring board 2 in the direction of lamination.

The plotted points of FIG. 5 represent values calculated by use of an analysis software program "ANSYS". In this analysis, the thermal expansion coefficients in the planar direction and Young's modulus of the solder 9 and the motherboard 10 were determined as shown in the table

Table 1

|  | Thermal expansion coefficient in planar direction | Young's modulus |
|---|---|---|
| solder 9 | $22 \times 10^{-6}$ 1/K | 32 GPa |
| Motherboard 10 | $16 \times 10^{-6}$ 1/K | 24 GPa |

below.

For the "thermal expansion coefficient of the wiring board 2 in the direction of lamination" of FIG. 5, a desired value can be obtained by adjusting the silica particle content in accordance with the relationship indicated in FIG. 6. Furthermore, the "equivalent plastic strain" in FIG. 5 means the plasticity of an equivalent strain from which the elasticity is excluded. As the value increases, cracks are more likely to occur in the soldered portion. The equivalent strain ($\varepsilon$) can be expressed by the following equation, where $\varepsilon 1$, $\varepsilon 2$, and $\varepsilon 3$ are main strains.

$$\varepsilon = \sqrt{\frac{1}{2}\left\{(\varepsilon 1 - \varepsilon 2)^2 + (\varepsilon 1 - \varepsilon 3)^2 + (\varepsilon 2 - \varepsilon 3)^2\right\}}$$

The inventors of the present invention conducted a test of repeating the temperature cycle of 125 to -40 degrees Celsius, with the thermal expansion coefficient of the wiring board 2 in the direction of lamination being set approximately to $60 \times 10^{-6}$ l/K. In this test, glass woven fabric was used for the material of the woven fabric 21 of the wiring board 2, an epoxy resin was used for the material of the resin adhesive of the resin adhesive layer 22, and the silica particle content in the resin adhesive layer 22 was set to 0 weight percent. Further, the side electrode 7 was coated with copper-nickel-gold plating, Sn-3Ag-0.5Cu was adopted for the material of the solder 9, and a glass epoxy print wiring board was adopted for the motherboard 10. As a result of this test, after approximately 300 temperature cycles, a crack was caused in the solder 9 in the vicinity of the lower part of the side portion 7a of the side electrode 7. As can be seen from the result of the test, a sufficient soldering reliability cannot be attained, even when the wiring board 2 is formed of the same material as that of the motherboard 10 (glass epoxy of 0 weight-percent silica particle content) to bring its thermal expansion coefficient in the planar direction in agreement with that of the motherboard 10.

In contrast, a similar temperature cycle test was conducted with the thermal expansion coefficient of the wiring board 2 in the direction of lamination being set approximately to $28 \times 10^{-6}$ 1/K. Here, the silica particle content of the resin adhesive layer 22 was determined approximately as 55 weight percent. As a result of this test, no crack was caused in the solder 9 after 1000 temperature cycles. As can be seen from FIG. 5, the equivalent plastic strain of the solder 9 is approximately 0.0004. Furthermore, when the thermal expansion coefficient of the wiring board 2 is within a range of approximately $15 \times 10^{-6}$ to $40 \times 10^{-6}$ 1/K, the equivalent plastic strain of the solder 9 is approximately 0.0004. Based on the above, the inventors of the present invention have judged that a sufficient soldering reliability can be attained when the thermal expansion coefficient of the wiring board 2 in the direction of lamination is within a range of approximately $15 \times 10^{-6}$ to $40 \times 10^{-6}$ 1/K.

The silica particle content that is required when the thermal expansion coefficient of the wiring board 2 in the direction of lamination approximately should be set in the range of $15 \times 10^{-6}$ and $40 \times 10^{-6}$ 1/K can be determined in accordance with the graph of FIG. 6. The plotted points of FIG. 6 are experimental values. In this test, glass fabric was used for the material of the woven fabric 21 of the wiring board 2, an epoxy resin was used for the material of the resin adhesive of the resin adhesive layer 22, and silica particles were used for the material of the inorganic filler particles of the resin adhesive layer 22.

As can be seen from FIG. 6, if the silica particle content of the resin adhesive layer 22 is set approximately to 30 to 80 weight percent, the thermal expansion coefficient of the wiring board 2 in the direction of lamination can be set approximately to $15 \times 10^{-6}$ to $40 \times 10^{-6}$ 1/K. Extrapolation was adopted to obtain the silica particle content of 80 weight percent for the thermal expansion coefficient of the wiring board 2 in the direction of lamination being approximately $15 \times 10^{-6}$. As can be seen from the above, a preferable range of the inorganic filler particle content is approximately between 30 and 80 weight percent.

In the above explanation of the present embodiment, the side electrode 7 includes the bottom portion 7b, but it is sufficient that the side electrode 7 is provided at least with the side portion 7a. When the side electrode 7 has the side portion 7a only, the semiconductor package 1 is mounted on the top surface of the motherboard 10 such that the end portions of the side electrodes 7 that extend to the bottom surface of the wiring board 2 are brought into contact with the motherboard electrodes 8, as illustrated in FIG. 7. Then, the solder 9 becomes spread and solderable between the side electrodes 7 of the semiconductor package 1 and the motherboard electrodes 8 of the motherboard 10.

In addition, according to the present embodiment, the woven fabric 21 of the wiring board 2, the resin adhesive of the resin adhesive layer 22, and the inorganic filler particles of the resin adhesive layer 22 each have layers that are formed of a single material to have the same content thereof, but different layers may have different materials as long as they can solve the problems of the present invention.

Still further, according to the present embodiment, the electrode recessed portions 2b are formed in the outer side surface of the wiring board 2, and the side portions 7a of the side electrodes 7 are arranged on the inner surfaces of the electrode recessed portions 2b, but as illustrated in FIG. 8, flat side portions 7a of the side electrodes 7 may be provided without preparing any electrode recessed portions on the outer side surface of the wiring board 2.

According to the present embodiment, the resin adhesive layers 22 of the wiring board 2 contain inorganic filler particles, and thereby the thermal expansion coefficient of the wiring board 2 in the direction of lamination (z axis direction) can be adjusted. In this manner, strain that tends to appear in the solder 9 in the vicinity of the side portions 7a of the side electrodes 7 can be reduced. Hence, cracks can be prevented from occurring in the soldered portion in an environment in which rise and drop of temperature is repeated.

Second Embodiment

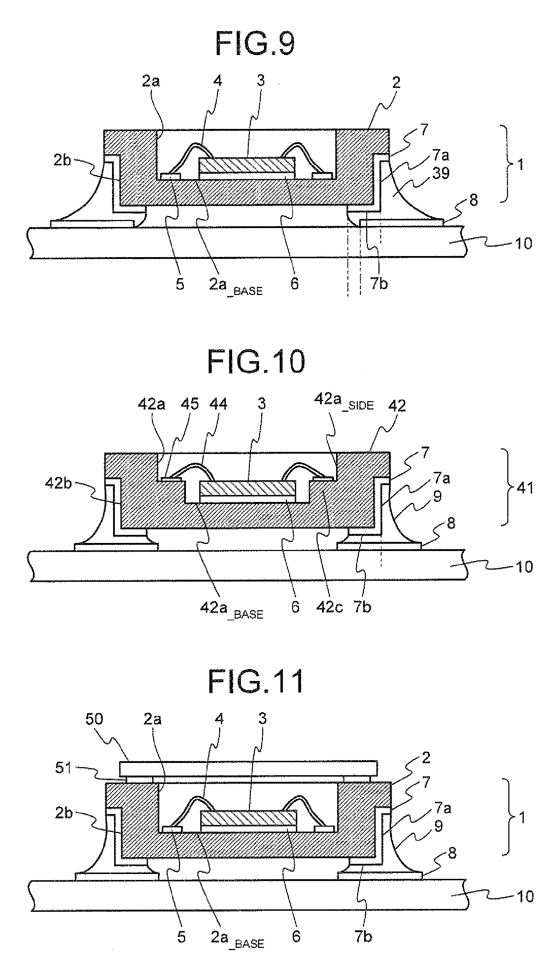

The second embodiment of the present invention is explained with reference to FIG. 9. FIG. 9 is a sectional view of the implementation structure of a semiconductor package according to the second embodiment of the present invention. Any portions the same as or equivalent to those of FIG. 3 are given the same numerals, and the explanation thereof is omitted here. In addition, the second to sixth embodiments are based essentially on the principles of the first embodiment.

A side electrode 7 and a motherboard electrode 8 are arranged such that a surface extending from the side portion 7a of the side electrode 7 (dotted line in FIG. 9) crosses the motherboard electrode 8. Moreover, the two are arranged, as indicated by the dashed double-dotted lines in FIG. 9, in such a manner that the inner end surface of the bottom portion 7b is positioned inside with respect to the inner end surface of the motherboard electrode 8 (toward the center of the wiring board 2). In other words, the size and the arrangement of the wiring board 2, the side electrode 7, or the motherboard electrode 8 are determined in such a manner that the distance between the inner end surfaces of the bottom portions 7b of the side electrodes 7 that face each other across the wiring board 2 is smaller than the distance between the inner end surfaces of the motherboard electrodes 8.

Hence, when soldering is performed between the side electrodes 7 and the motherboard electrodes 8, a solder 39 spreads out and becomes solderable between the top and inner end surfaces of the motherboard electrodes 8 and the bottom portions 7b and the side portions 7a of the side electrodes 7, and it extrudes into a convex shape toward the center of the wiring board 2 under a surface tension of the solder 39.

According to the present embodiment, in addition to the advantageous effects of the first embodiment, the solder 39 spreads to the inner end surfaces of the motherboard electrodes 8 and becomes solderable there, and it extrudes into a convex shape toward the center of the wiring board 2 under the surface tension of the solder 39 so that the soldering area can be increased. As a result, the strain in the solder 39 can be reduced. Thus, cracks can be prevented from occurring in the soldered portion in an environment in which rise and fall of temperature are repeated.

Third Embodiment

The third embodiment of the present invention is explained with reference to FIG. 10. FIG. 10 is a sectional view of the implementation structure of a semiconductor package according to the third embodiment of the present invention. Any portions the same as or equivalent to those of FIG. 3 are given the same numerals, and the explanation thereof is omitted here.

A semiconductor package 41 includes a wiring board 42, the semiconductor element 3, element electrodes 45, and the side electrodes 7. In a similar manner to the wiring board 2 according to the first embodiment, the wiring board 42 is internally wired by a not-shown conductive body, and it is formed by alternately laminating the woven fabric and resin adhesive layer that contains inorganic filler particles. Furthermore, the wiring board 42 includes an element housing recessed portion 42a in its top surface to house the semiconductor element 3, and it also includes multiple electrode recessed portions 42b on a pair of outer side surfaces that oppose each other to extend from the bottom surface to the vicinity of the top surface.

A step portion 42c is formed on an inner side surface $42a_{SIDE}$ of the element housing recessed portion 42a. In other words, the horizontal cross-sectional area of the element housing recessed portion 42a below the step portion 42c is smaller than the horizontal cross-sectional area above the step portion 42c. The semiconductor element 3 is fixed to a bottom surface $42a_{BASE}$ of the element housing recessed portion 42a with the adhesive 6, and the element electrode 45 is arranged on the top surface of the step portion 42c. The step portion 42c is provided approximately at the same height as the top surface of the semiconductor element 3. Then, the semiconductor element 3 and the element electrode 45 are electrically connected to each other by way of a wire 44, and the element electrode 45 and the side electrodes 7 are electrically connected to each other by the inner wiring of the wiring board 42.

According to the present embodiment, in addition to the advantageous effects of the first embodiment, by providing the step portion 42c on the inner side surface $42a_{SIDE}$ of the element housing recessed portion 42a, the cross-sectional area of the lower corner portion of the wiring board 42 in the planar direction can be increased. As a result, the wiring board 42 can be prevented from being deformed, and the strain in the solder 9 can be reduced. Thus, cracks can be prevented from occurring in the soldered portion in an environment in which rise and fall of temperature are repeated. In addition, by arranging the step portion 42c approximately at the same height as the top surface of the semiconductor element 3, the length of the wire 44 that connects the semiconductor element 3 to the element electrode 45 can be reduced. In this manner, noise can be suppressed.

Fourth Embodiment

The fourth embodiment of the present invention is explained with reference to FIG. 11. FIG. 11 is a sectional view of the implementation structure of a semiconductor package according to the fourth embodiment of the present invention. Any portions the same as or equivalent to those of FIG. 3 are given the same numerals, and the explanation thereof is omitted here.

A cover 50 is fixed onto the top surface of the wiring board 2 to cover the opening of the element housing recessed portion 2a. The cover 50 has a rectangular outer shape that is larger than the opening of the element housing recessed portion 2a, and is fixed by a fixing unit 51 that is arranged on the top surface of the wiring board 2 so that the entire opening of the element housing recessed portion 2a can be covered. The cover 50 serves to suppress the deformation of the top portion of the wiring board 2, and plastic or glass may be adopted as the material of the cover 50. As the material of the fixing unit 51, a thermoset resin such as an epoxy resin, an ultraviolet curable resin, a thermoplastic resin, and solder may be adopted.

Furthermore, the shape, area, and arrangement of the cover 50 are not limited to the above, as long as the deformation of the top portion of the wiring board 2 can be suppressed. For example, it may be formed into a bar shape that has a width, when viewed from above, being greater than the width of the opening of the element housing recessed portion 2a and a length being smaller than the length of the element housing recessed portion 2a. In addition, shapes may be formed in the wiring board 2 and the cover 50 to be engaged with each other so that the cover 50 may be fixed directly to the wiring board 2, instead of fixing with the fixing unit 51.

According to the present embodiment, in addition to the advantageous effects of the first embodiment, by arranging the cover 50 that is fixed onto the top surface of the wiring board 2 to partially or entirely cover the opening of the element housing recessed portion 2a, deformation of the top portion of the wiring board 2 can be suppressed, and the strain in the solder 9 can be reduced. Hence, cracks can be prevented from appearing in the soldered portion in an environment in which rise and fall of the temperature are repeated. Moreover, the entire opening is covered to hermetically seal the element housing recessed portion 2a with the cover 50 so that dust is prevented from entering the element housing recessed portion 2a.

Fifth Embodiment

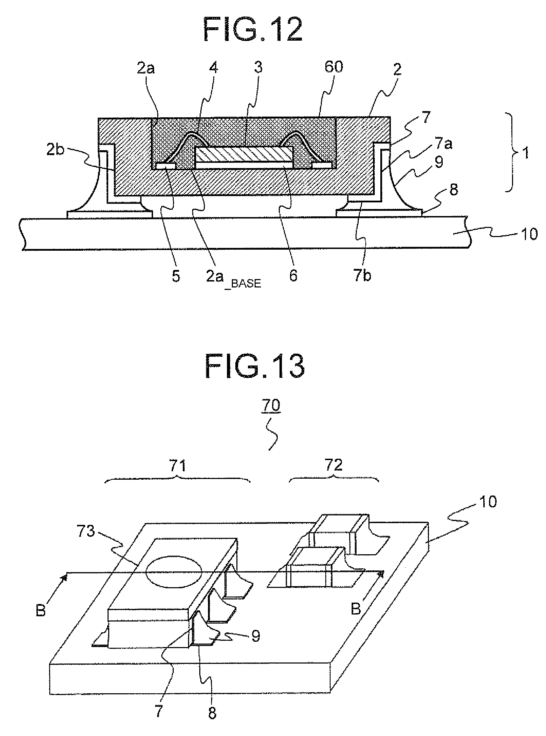

The fifth embodiment of the present invention is explained with reference to FIG. 12. FIG. 12 is a sectional view of the implementation structure of a semiconductor package according to the fifth embodiment of the present invention. Any portions the same as or equivalent to those of FIG. 3 are given the same numerals, and the explanation thereof is omitted here.

The element housing recessed portion 2a of the wiring board 2 in which the semiconductor element 3 is housed is filled with a resin 60. The resin 60 serves to fix the wiring board 2 and suppress the deformation. As the material of the resin 60, silicon gel or silicon rubber may be adopted. In addition, the resin 60 may be provided only in the vicinity of the boundary between the bottom surface $2a_{\_BASE}$ and an inner side surface $2a_{\_SIDE}$ of the element housing recessed portion 2a to suppress the deformation of the lower portion of the wiring board 2.

According to the present embodiment, in addition to the advantageous effects of the first embodiment, the element housing recessed portion 2a is partially or entirely filled with the resin 60 so that the deformation of at least the lower portion of the wiring board 2 can be suppressed, and the strain in the solder 9 can be reduced. Hence, cracks can be prevented from occurring in the soldered portion in an environment in which rise and fall of temperature are repeated. In addition, because the element housing recessed portion 2a is hermetically sealed with the resin 60, dust is prevented from entering the element housing recessed portion 2a.

Sixth Embodiment

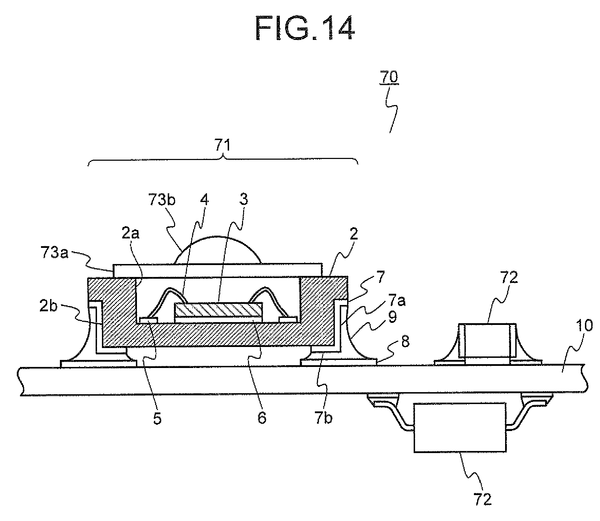

The sixth embodiment of the present invention is explained with reference to FIGS. 13 and 14. FIG. 13 is a perspective view of an optical semiconductor module according to the sixth embodiment of the present invention, and FIG. 14 is a section B-B of the optical semiconductor module according to the sixth embodiment of the present invention. Any portions the same as or equivalent to those of FIG. 3 are given the same numerals, and the explanation thereof is omitted here.

An optical semiconductor module 70 includes an optical semiconductor package 71 and multiple electronic parts 72 on the motherboard 10. The electronic parts 72 are mounted on the surface of the motherboard 10 on which the optical semiconductor package 71 is mounted and the other surface thereof by soldering. The optical semiconductor package 71 incorporates an emitting semiconductor element as the semiconductor element 3 of the semiconductor package 1, and a lens 73 is positioned on the top surface of the wiring board 2.

The lens 73 includes a board portion 73a that has a horizontal cross-sectional area larger than the horizontal area of the opening of the element housing recessed portion 2a and is mounted on the top surface of the wiring board 2 so as to cover the opening of the element housing recessed portion 2a; and a convex portion 73b arranged at the position opposite of the semiconductor element 3 on a surface of the board portion 73a opposite of the surface that is in contact with the wiring board 2.
The surface of the convex portion 73b that is in contact with the board portion 73a is circular and rises outward approximately in a hemisphere shape. The shape of the lens 73 is not limited thereto, however. The light emitted from the semiconductor element 3 passes through the lens 73 to the outside.

According to the present embodiment, in addition to the advantageous effects of the first embodiment, the distance between the lens 73 and the semiconductor element 3 can be prevented from varying. Hence, a high-quality optical semiconductor module that has a stable light emission property can be achieved.

Reference Signs List

1, 41 SEMICONDUCTOR PACKAGE
2, 42 WIRING BOARD
2a, 42a ELEMENT HOUSING RECESSED PORTION
2b, 42b ELECTRODE RECESSED PORTION
$2a_{SIDE}$, $42a_{SIDE}$ INNER SIDE SURFACE OF RECESSED PORTION
$2a_{BASE}$, $42a_{BASE}$ BOTTOM SURFACE OF RECESSED PORTION
3 SEMICONDUCTOR ELEMENT
5, 45 ELEMENT ELECTRODE
7 SIDE ELECTRODE
7a SIDE PORTION OF SIDE ELECTRODE
7b BOTTOM PORTION OF SIDE ELECTRODE
8 MOTHERBODARD ELECTRODE
9, 39 SOLDER
10 MOTHERBOARD
21 WOVEN FABRIC
22 RESIN ADHESIVE LAYER
42c STEP PORTION
50 COVER
60 RESIN
70 OPTICAL SEMICONDUCTOR MODULE
71 OPTICAL SEMICONDUCTOR PACKAGE
73 LENS

**Claims**

1. A semiconductor package (1; 41) comprising:

   a package wiring board (2; 42) which has an element housing recessed portion (2a; 42a) on a top surface thereof for housing a semiconductor element (3);
   a plurality of side electrodes (7) which are arranged on outer side surfaces of the package wiring board (2; 42) and soldered to a plurality of motherboard electrodes (8) arranged on a motherboard (10);
   a semiconductor element (3) which is fixed onto a bottom surface of the element housing recessed portion (2a; 42a);, and
   an element electrode (5; 45) arranged on the bottom surface of the element housing recessed portion (2a; 42a) and electrically connected to the semiconductor element (3) and the side electrodes (7),
   the package wiring board (2; 42) has a multilayered structure in which woven fabric (21) and a resin adhesive layer (22) are alternately laminated, a top surface of the multilayered structure being cut off to form the element housing recessed portion (2a; 42a) ;
   **characterized in that**
   the package wiring board (2; 42) is internally wired by a conductive material to electrically connect the side electrode (7) and the element electrode (5, 45); and
   the resin adhesive layer (22) is formed of a resin adhesive that contains inorganic filler particles; and
   wherein on the outer side surfaces of the package wiring board (2; 42) electrode recessed portions (2b) are formed into semicircular columns, designed to cut through a bottom surface of the wiring board (2; 42), but not the top surface thereof and side portions (7a) of the side electrodes (7) are arranged on each recessed portion (2b).

2. The semiconductor package (41) according to claim 1, wherein a step portion (42c) is arranged on an inner side surface of the element housing recessed portion (42a) at same level as a top surface of the semiconductor element (3), and the element electrode (45) is arranged on a top surface of the step portion (42c).

3. The semiconductor package according to claim 1, further comprising a cover (50) which is fixed on a top surface of the package wiring board (2; 42) to partially or entirely cover an opening of the element housing recessed portion (2a; 42a).

4. The semiconductor package according to claim 1, wherein the element housing recessed portion (2a; 42a) is partially or entirely filled with resin.

5. The semiconductor package according to claim 1, wherein
the motherboard (10) is a glass epoxy print wiring board;
the solder (9; 39) is lead-free solder; and
a thermal expansion coefficient of the package wiring board (2; 42) in a direction of lamination is determined between $15\times10^{-6}$ and $40\times10^{-6}$ 1/K.

6. The semiconductor package according to claim 1, wherein
the motherboard (10) is a glass epoxy print wiring board;
the solder (9; 39) is lead-free solder; and
a content of the inorganic filler particles in the resin adhesive layer (22) is 30 to 80 weight percent.

7. A semiconductor package implementation structure comprising:

the semiconductor package (1; 41) according to any one of claims 1 to 6;
a motherboard (10) on which the semiconductor package (1; 41) is mounted;
a plurality of motherboard electrodes (8) which are arranged on a surface of the motherboard (10) and attached to the side electrodes (7) by use of solder (9; 39), wherein
the side electrodes and the motherboard electrodes (8) are arranged in such a manner that surfaces extending from the side electrodes (7) cross the motherboard electrodes (8); and
the solder (9; 39) is spread and becomes solderable between top surfaces of the motherboard electrodes (8) and the side electrodes (7).

8. The semiconductor package implementation structure according to claim 7, wherein
the side electrodes (7) are each provided by integrally forming a side portion (7a) arranged on the outer side surface of the package wiring board (2; 42) and a bottom portion (7b) arranged on a bottom surface of the package wiring board (2; 42);
the side electrodes (7) and the motherboard electrodes (8) are arranged in such a manner that surfaces extending from the side portions of the side electrodes (7) cross the motherboard electrodes (8), and inner end surfaces of the bottom portions of the side electrodes (7) are positioned inside with respect to inner end surfaces of the motherboard electrodes (8); and
the solder (9; 39) is spread and becomes solderable between the top surfaces and the inner end surfaces of the motherboard electrodes (8) and the side electrodes (7).

9. The semiconductor package implementation structure according to claim 7, further comprising a lens (73) mounted on the top surface of the package wiring board (2; 42),
wherein the semiconductor element (3) is a light emitting semiconductor element.


**Patentansprüche**

1. Halbleitergehäuse (1; 41) mit:

einer Verdrahtungsplatteneinheit (2; 42), die an einer oberen Fläche davon einen ausgenommenen Bauteil-Aufnahmeabschnitt (2a; 42a) zur Aufnahme eines Halbleiterbauteils (3) aufweist;
mehreren seitlichen Elektroden (7), welche an äußeren Seitenflächen der Verdrahtungsplatteneinheit (2; 42) angeordnet sind und mit mehreren an einem Motherboard (10) angeordneten Motherboard-Elektroden (8) verlötet sind;
einem Halbleiterbauteil (3), das an einer Bodenfläche des ausgenommenen Bauteil-Aufnahmeabschnitts (2a; 42a) befestigt ist; und
einer Bauteilelektrode (5, 45), die an der Bodenfläche des ausgenommenen Bauteil-Aufnahmeabschnitts (2a; 42) angeordnet ist und mit dem Halbleiterbauteil (3) und den seitlichen Elektroden (7) elektrisch verbunden ist,
wobei die Verdrahtungsplatteneinheit (2; 42) eine Mehrschichtstruktur aufweist, bei der ein Gewebe (21) und eine Harz-Haftmittelschicht (22) abwechselnd geschichtet sind, wobei eine obere Fläche der Mehrschichtstruktur derart abgeschnitten ist, dass der ausgenommene Bauteil-Aufnahmeabschnitt (2a; 42a) ausgebildet ist; **dadurch gekennzeichnet, dass**

die Verdrahtungsplatteneinheit (2; 42) durch ein leitfähiges Material innenliegend derart verdrahtet ist, dass sie die seitliche Elektrode (7) und die Bauteilelektrode (5; 45) verbindet; und

die Harz-Haftmittelschicht (22) aus einem Harz-Haftmittel ausgebildet ist, das anorganische Füllpartikel enthält, und

wobei an den äußeren Seitenflächen der Verdrahtungsplatteneinheit (2; 42) ausgenommene Abschnitte (2b) für Elektroden in halbkreisförmigen Säulen ausgebildet sind, die derart ausgestaltet sind, dass sie durch eine Bodenfläche der Verdrahtungsplatte (2; 42), nicht aber durch die obere Fläche davon treten, und seitliche Abschnitte (7a) der seitlichen Elektroden (7) an jedem ausgenommenen Abschnitt (2b) angeordnet sind.

2. Halbleitergehäuse (41) nach Anspruch 1, bei dem ein Stufenabschnitt (42c) an einer inneren Seitenfläche des ausgenommenen Bauteil-Aufnahmeabschnitts (42a) auf dem gleichen Niveau angeordnet ist, wie eine obere Fläche des Halbleiterbauteils (3), und die Bauteilelektrode (45) an einer oberen Fläche des Stufenabschnitts (42c) angeordnet ist.

3. Halbleitergehäuse gemäß Anspruch 1, ferner mit einer Abdeckung (50), die an einer oberen Fläche der Verdrahtungsplatteneinheit (2; 42) derart befestigt ist, dass sie eine Öffnung des ausgenommenen Bauteil-Aufnahmeabschnitts (2a; 42a) teilweise oder vollständig bedeckt.

4. Halbleitergehäuse nach Anspruch 1, bei dem der ausgenommenen Bauteil-Aufnahmeabschnitt (2a; 42a) vollständig oder teilweise mit Harz gefüllt ist.

5. Halbleitergehäuse nach Anspruch 1, bei dem
das Motherboard (10) eine gedruckte Glas-Epoxy-Verdrahtungsplatte ist;
das Lötmaterial (9; 39) ein bleifreies Lötmaterial ist; und
ein thermischer Expansionskoeffizient der Verdrahtungsplatteneinheit (2, 42) in einer Schichtungsrichtung auf $15x10^{-6}$ und $40x10^{-6}$ 1/K festgelegt ist.

6. Halbleitergehäuse nach Anspruch 1, bei dem
das Motherboard (10) eine gedruckte Glas-Epoxy-Verdrahtungsplatine ist;
das Lötmaterial (9; 39) ein bleifreies Lötmaterial ist; und
ein Gehalt der anorganischen Füllpartikel in der Harz-Haftmittelschicht (22) 30 bis 80 Gewichtsprozent beträgt.

7. Halbleitergehäuse-Montagestruktur mit:

einem Halbleitergehäuse (1; 41) nach einem der Ansprüche 1 bis 6;
einem Motherboard (10), auf dem das Halbleitergehäuse (1; 41) angebracht ist;
mehreren Motherboard-Elektroden (8), die an einer Oberfläche des Motherboards (10) angeordnet sind und unter Verwendung von Lötmaterial (9; 39) mit den seitlichen Elektroden (7) verbunden sind, wobei
die seitlichen Elektroden und die Motherboard-Elektroden (8) derart angeordnet sind, dass Oberflächen, die sich von den seitlichen Elektroden (7) erstrecken, die Motherboard-Elektroden (8) kreuzen; und
das Lötmaterial (9; 39) zwischen oberen Flächen der Motherboard-Elektroden (8) und den seitlichen Elektroden (7) dispergiert ist und verlötbar wird.

8. Halbleiter-Montagestruktur nach Anspruch 7, bei der
die seitlichen Elektroden (7) jeweils durch integrales Ausbilden eines auf der Außenseitenfläche der Verdrahtungsplatteneinheit (2; 42) angeordneten seitlichen Abschnitts (7a) und eines an einer Bodenfläche der Verdrahtungsplatteneinheit (2; 42) angeordneten Bodenabschnitts (7b) ausgebildet sind;
die seitlichen Elektroden (7) und die Motherboard-Elektroden (8) derart angeordnet sind, dass sich von den seitlichen Abschnitten der seitlichen Elektroden (7) erstreckende Oberflächen die Motherboard-Elektroden (8) kreuzen und innere Endflächen der Bodenabschnitte der seitlichen Elektroden (7) bezüglich innenliegenden Endflächen der Motherboard-Elektroden (8) innenliegend angeordnet sind; und
das Lötmaterial (9; 39) zwischen den oberen Flächen und den inneren Endflächen der Motherboard-Elektroden (8) und der seitlichen Elektroden (7) dispergiert ist und verlötbar wird.

9. Halbleitergehäuse-Montagestruktur nach Anspruch 7, ferner mit einer Linse (73), die an der oberen Fläche der Verdrahtungsplatteneinheit (2; 42) angebracht ist,

wobei das Halbleiterbauteil (3) ein lichtemittierendes Halbleiterbauteil ist.

**Revendications**

1.  Boîtier de semi-conducteur (1 ; 41) comprenant :

    une carte de câblage de boîtier (2 ; 42) qui a une portion évidée de logement d'élément (2a ; 42a) sur une surface supérieure de celle-ci pour loger un élément semi-conducteur (3) ;
    une pluralité d'électrodes latérales (7) qui sont agencées sur des surfaces latérales externes de la carte de câblage de boîtier (2 ; 42) et soudées à une pluralité d'électrodes de carte mère (8) agencées sur une carte mère (10) ;
    un élément semi-conducteur (3) qui est fixé sur une surface inférieure de la portion évidée de logement d'élément (2a ; 42a) ; et
    une électrode d'élément (5 ; 45) agencée sur la surface inférieure de la portion évidée de logement d'élément (2a ; 42a) et connectée électriquement à l'élément semi-conducteur (3) et aux électrodes latérales (7),
    la carte de câblage de boîtier (2 ; 42) a une structure multicouche dans laquelle un tissu tissé (21) et une couche adhésive de résine (22) sont stratifiées en alternance, une surface supérieure de la structure multicouche étant découpée pour former la portion évidée de logement d'élément (2a ; 42a) ;

    **caractérisé en ce que** :

    la carte de câblage de boîtier (2 ; i 42) est câblée intérieurement par un matériau conducteur pour connecter électriquement l'électrode latérale (7) et l'électrode d'élément (5, 45) ; et
    la couche adhésive de résine (22) est formée d'un adhésif de résine qui contient des particules de charge inorganiques ; et
    dans lequel, sur les surfaces latérales externes de la carte de câblage de boîtier (2 ; 42), des portions évidées d'électrodes (2b) sont conformées en colonnes semi-circulaires, conçues pour traverser une surface inférieure de la carte de câblage (2 ; 42), mais pas la surface supérieure de celle-ci, et des portions latérales (7a) des électrodes latérales (7) sont agencées sur chaque portion évidée (2b).

2.  Boîtier de semi-conducteur (41) selon la revendication 1, dans lequel une portion étagée (42c) est agencée sur une surface côté interne de la portion évidée de logement d'élément (42a) au même niveau qu'une surface supérieure de l'élément semi-conducteur (3), et l'électrode d'élément (45) est agencée sur une surface supérieure de la portion étagée (42c).

3.  Boîtier de semi-conducteur selon la revendication 1, comprenant en outre un couvercle (50) qui est fixé sur une surface supérieure de la carte de câblage de boîtier (2 ; 42) pour couvrir partiellement ou entièrement une ouverture de la portion évidée de logement d'élément (2a ; 42a).

4.  Boîtier de semi-conducteur selon la revendication 1, dans lequel la portion évidée de logement d'élément (2a ; 42a) est partiellement ou entièrement remplie de résine.

5.  Boîtier de semi-conducteur selon la revendication 1, dans lequel :

    la carte mère (10) est une carte de câblage imprimée de verre-époxyde ;
    la soudure (9 ; 39) est une soudure sans plomb ; et
    un coefficient de dilatation thermique de la carte de câblage de boîtier (2 ; 42) dans une direction de stratification est déterminé entre $15 \times 10^{-6}$ et $40 \times 10^{-6}$ 1/K.

6.  Boîtier de semi-conducteur selon la revendication 1, dans lequel :

    la carte mère (10) est une carte de câblage imprimée de verre-époxyde ;
    la soudure (9 ; 39) est une soudure sans plomb ; et
    la teneur en particules de charge inorganiques de la couche adhésive de résine (22) est de 30 à 80 pour cent en poids.

7.  Structure d'application de boîtier de semi-conducteur, comprenant :

le boîtier de semi-conducteur (1 ; 41) selon l'une quelconque des revendications 1 à 6 ;
une carte mère (10) sur laquelle le boîtier de semi-conducteur (1 ; 41) est monté ;
une pluralité d'électrodes de carte mère (8) qui sont agencées sur une surface de la carte mère (10) et fixées aux électrodes latérales (7) à l'aide d'une soudure (9 ; 39), dans laquelle :

les électrodes latérales et les électrodes de carte mère (8) sont agencées d'une façon telle que les surfaces s'étendant des électrodes latérales (7) coupent les électrodes de carte mère (8) ; et
la soudure (9 ; 39) est étalée et devient soudable entre les surfaces supérieures des électrodes de carte mère (8) et des électrodes latérales (7).

8. Structure d'application de boîtier de semi-conducteur selon la revendication 7, dans laquelle :

les électrodes latérales (7) sont chacune ménagées en formant d'un seul tenant une portion latérale (7a) agencée sur la surface latérale externe de la carte de câblage de boîtier (2 ; 42) et une portion inférieure (7b) agencée sur une surface inférieure de la carte de câblage de boîtier (2 ; 42) ;
les électrodes latérales (7) et les électrodes de carte mère (8) sont agencées d'une façon telle que les surfaces s'étendant des portions latérales des électrodes latérales (7) coupent les électrodes de carte mère (8), et les surfaces d'extrémité internes des portions inférieures des électrodes latérales (7) sont positionnées à l'intérieur par rapport aux surfaces d'extrémité internes des électrodes de carte mère (8) ; et
la soudure (9 ; 39) est étalée et devient soudable entre les surfaces supérieures et les surfaces d'extrémité internes des électrodes de carte mère (8) et des électrodes latérales (7).

9. Structure d'application de boîtier de semi-conducteur selon la revendication 7, comprenant en outre une lentille (73) montée sur la surface supérieure de la carte de câblage de boîtier (2 ; 42),
dans laquelle l'élément semi-conducteur (3) est un élément semi-conducteur électroluminescent.

# FIG.1

# FIG.2

# FIG.3

# FIG.4

# FIG.5

THERMAL EXPANSION COEFFICIENT
OF WIRING BOARD 2 IN LAMINATION
DIRECTION [$10^{-6}$/K]

# FIG.6

# FIG.7

# FIG.8

# FIG.9

# FIG.10

# FIG.11

# FIG.12

# FIG.13

# FIG.14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9326545 B
- JP 2007200997 A
- JP 11150211 A
- US 5677045 A
- WO 2008059741 A1
- US 4872825 A
- EP 1534054 A2
- JP 2004140385 A
- US 20070057364 A1

**Non-patent literature cited in the description**

- Electronics implementation technique basic course. Erekutoronikusu Jisso Gijutsu Kiso Koza. Kogyo Chosakai Publishing, Co., Ltd, 1997, vol. 4, 158